# EUROPEAN PATENT APPLICATION

(11) **EP 4 811 658 A1**
(43) Date of publication of application: **23.09.2026**
(21) Application number: 24890452.6
(22) Date of filing: 23.10.2024
(51) Int. Cl.: H03H 9/64, H03H 9/02, H03H 9/05, H03H 3/08

(54) **ACOUSTIC SURFACE WAVE FILTER PACKAGING STRUCTURE AND MANUFACTURING METHOD THEREFOR**

(30) Priority: 13.11.2023 CN 202311509702
(71) Applicant: Vanchip (Tianjin) Technology Co. Ltd, Tianjin 300457 (CN)
(72) Inventor: YU, Caixiang, Tianjin 300457 (CN); PENG, Yanjun, Tianjin 300457 (CN); HONG, Shengping, Tianjin 300457 (CN); LIN, Hongkuan, Tianjin 300457 (CN); ZHOU, Bin, Tianjin 300457 (CN)
(74) Representative: Patentship Patentanwaltsgesellschaft mbH
(86) International application number: PCT/CN2024/126592
(87) International publication number: WO 2025/103095

(57) **Abstract**

The present invention provides a surface acoustic wave (SAW) filter packaging structure and a method of manufacturing the structure, in which a ring-shaped metal wiring structure formed on a substrate and a ring-shaped metal pad formed on a carrier are connected to each other to together define a barrier wall structure, which blocks the influence of encapsulation, thereby providing very high stability and reliability. In addition, the ring-shaped metal wiring structure formed on the substrate and the ring-shaped metal pad formed on the carrier are both simple in structure, resulting in reductions in process complexity and fabrication cost

## Description

### TECHNICAL FIELD

The present invention relates to the field of communication technology, and more particularly to a surface acoustic wave (SAW) filter packaging structure and a method of making the structure.

### BACKGROUND

Mobile phones have evolved over generations, and more recent ones offer richer functionalities. In this context, the demand for data communication services is ever increasing, necessitating more efficient utilization of spectrum resources. In order to ensure a sufficient spectral bandwidth available for allocation to a large number of simultaneously communicating mobile phones over a network, each single mobile phone is desired to cover a wide range of frequency bands. RF front-end modules used for this purpose may incorporate radio frequency (RF) filters, which reject out-of-band interference and noise to provide a signal-to-noise ratio (SNR) to the RF systems and communication protocols. As mobile phones are required to support more and more frequency bands, the number of corresponding filters integrated in them is increasing.

A surface acoustic wave (SAW) filter delivers its filtering functionality through vibration of an interdigital transducer (IDT) arranged on its surface. Therefore, the structural integrity must be ensured for a hollow cavity on top of the IDT surface. A number of SAW filter packaging approaches have been established in the art.
1. Wafer-level packaging (WLP) involves forming, on a wafer, hollow cavities each delimited by a wall and a roof. After the wafer is singulated, the resulting dies are directly mounted to the surface of a substrate and then encapsulated. Despite high reliability, this packaging approach is costly.
2. Taping involves covering the singulated individual dies, which have been directly mounted to the substrate surface, with a polymer tape for blocking an encapsulating material used in the subsequent encapsulation process from ingress into the IDTs. This approach suffers from poor stability, and the polymer tape is expensive as a consumable.

Therefore, there remains a need in the art for a reliable, inexpensive SAW filter packaging structure.

### SUMMARY

It is an object of the present invention to overcome the problems of poor reliability and/or expensiveness associated with conventional surface acoustic wave (SAW) filter packaging structures by presenting a novel SAW filter packaging structure and method of manufacturing such a structure.

To this end, the present invention provides an SAW filter packaging structure including:
a chip structure including a substrate, an interdigital transducer (IDT) formed on the substrate and a ring-shaped metal wiring structure formed on the substrate, the ring-shaped metal wiring structure defining an accommodation space, the IDT disposed within the accommodation space;
a carrier structure including a carrier and a ring-shaped metal pad formed on the carrier, the carrier structure bonded to the chip structure so that the ring-shaped metal pad and the ring-shaped metal wiring structure are connected to each other to together define a barrier wall structure; and
a plastic packaging layer, which is located between the chip structure and the carrier structure so as to surround the barrier wall structure.

Optionally, in the SAW filter packaging structure, the ring-shaped metal pad and the ring-shaped metal wiring structure may be connected to each other by soldering with a solder paste or flux, or by an applied adhesive or adhesive tape.

Optionally, in the SAW filter packaging structure, at least part of the ring-shaped metal wiring structure may reside on at least part of the ring-shaped metal pad.

Optionally, in the SAW filter packaging structure, the ring-shaped metal pad may have an annular width, which is greater than or equal to an annular width of the ring-shaped metal wiring structure.

Optionally, in the SAW filter packaging structure, at least one of edges of the ring-shaped metal pad may be located beyond a respective at least one of respective edges of the ring-shaped metal wiring structure.

Optionally, in the SAW filter packaging structure, the carrier structure may further include a solder mask layer formed on the carrier, from which the ring-shaped metal pad is exposed.

Optionally, in the SAW filter packaging structure, the chip structure may further include a plurality of metal bump structures formed on the substrate.

Optionally, in the SAW filter packaging structure, the carrier structure may further include solder pads formed on the carrier, which are connected to the metal bump structures.

Optionally, in the SAW filter packaging structure, the plastic packaging layer may extend over at least part of the chip structure.

The present invention also provides a method of manufacturing an SAW filter packaging structure, which includes:
providing a chip structure including a substrate, an IDT formed on the substrate and a ring-shaped metal wiring structure formed on the substrate, the ring-shaped metal wiring structure defining an accommodation space, the IDT disposed within the accommodation space;
providing a carrier structure including a carrier and a ring-shaped metal pad formed on the carrier;
mounting the chip structure and the carrier structure so that they are bonded together so that the ring-shaped metal pad and the ring-shaped metal wiring structure are connected to each other to together define a barrier wall structure; and
forming a plastic packaging layer between the chip structure and the carrier structure, which surrounds the barrier wall structure.

Optionally, in the method, providing the chip structure may include:
providing a wafer defining a plurality of device areas;
forming, in each of the device areas, the ring-shaped metal wiring structure that defines the accommodation space and the IDT that is disposed within the accommodation space; and
dicing the wafer into a plurality of the chip structures, in each of which the wafer serves as the substrate.

Optionally, in the method, the chip structure and the carrier structure may be mounted by soldering with a printed solder paste or flux, or by an applied adhesive or adhesive tape so that they are bonded together so that the ring-shaped metal pad and the ring-shaped metal wiring structure are connected to each other to together define the barrier wall structure.

Optionally, in the method, the provided chip structure may further include a plurality of metal bump structures formed on the substrate, wherein:
the provided carrier structure further includes solder pads formed on the carrier; and
the chip structure and the carrier structure are mounted so that the solder pads are connected to the metal bump structures.

As noted above, the present invention provides an SAW filter packaging structure and a method of manufacturing the structure, in which a ring-shaped metal wiring structure formed on a substrate and a ring-shaped metal pad formed on a carrier are connected to each other to together define a barrier wall structure, which blocks the influence of encapsulation, thereby providing very high stability and reliability. In addition, the ring-shaped metal wiring structure formed on the substrate and the ring-shaped metal pad formed on the carrier are both simple in structure, resulting in reductions in process complexity and fabrication cost.

### BRIEF DESCRIPTION OF THE DRAWINGS

Fig. 1 shows a schematic cross-sectional view of a surface acoustic wave (SAW) filter packaging structure according to an embodiment of the present invention.
Fig. 2 shows a schematic top view of a chip structure according to an embodiment of the present invention.
Fig. 3 shows a schematic top view of a carrier structure according to an embodiment of the present invention.
Fig. 4 shows a schematic flowchart of a method of manufacturing an SAW filter packaging structure according to an embodiment of the present invention.

### List of Reference Numerals

10 SAW filter packaging structure;
100 chip structure; 110 substrate; 120 IDT; 130 ring-shaped metal wiring structure; 140 accommodation space; 150 metal bump structure;
200 carrier structure; 210 carrier; 220 ring-shaped metal pad; 230 solder mask layer; 240 solder pad;
300 plastic packaging layer;
400 hollow cavity; 410 barrier wall structure;
W1, W2 annular width.

### DETAILED DESCRIPTION

Surface acoustic wave (SAW) filter packaging structures and methods of manufacturing such a packaging structure proposed in specific embodiments of the present invention will be described in greater detail below with reference to the accompanying drawings. From the following description, advantages and features of the present invention will become more apparent. Note that the figures are provided in a very simplified form not necessarily drawn to exact scale for the only purpose of facilitating easy and clear description of the embodiments disclosed herein.

The terminology used herein is for the purpose of describing particular embodiments only and is not intended to be limiting of the invention. Unless defined otherwise herein, all technical and scientific terms used herein have the same meaning as commonly understood by one of ordinary skill in the art to which the invention belongs. As used herein and in the appended claims, the terms "first," "second," and the like do not denote any order, quantity, or importance, but rather are used to distinguish one element from another. Likewise, the terms "a", "an" and the like do not denote a limitation of quantity, but rather denote the presence of at least one of the referenced items. The terms "plurality" or "several" means two or more than two. Unless defined otherwise herein, the terms "upper", "upper layer", "lower", "lower layer" and/or the like are merely for ease of description, and should not be construed as being limited to a particular position, or to a particular spatial orientation. The use of "including" or "comprising" or the like herein is meant to encompass the elements or items listed thereafter and equivalents thereof but do not preclude the presence of other elements or items. The terms "connected", "coupled" or the like are not restricted to physical or mechanical connections or couplings, and can include electrical connections or couplings, whether direct or indirect. As used herein and in the appended claims, the singular forms "a", "an", and "the" are intended to include the plural forms as well, unless the context clearly indicates otherwise. It will be also understood that, as used herein, the term "and/or" includes any and all combinations of one or more of the associated listed items.

In principle, the present invention seeks to provide an SAW filter packaging structure and a method of manufacturing the structure, in which a ring-shaped metal wiring structure formed on a substrate and a ring-shaped metal pad formed on a carrier are connected to each other to together define a barrier wall structure, which blocks the influence of encapsulation, thereby providing very high stability and reliability. In addition, the ring-shaped metal wiring structure formed on the substrate and the ring-shaped metal pad formed on the carrier are both simple in structure, resulting in reductions in process complexity and fabrication cost.

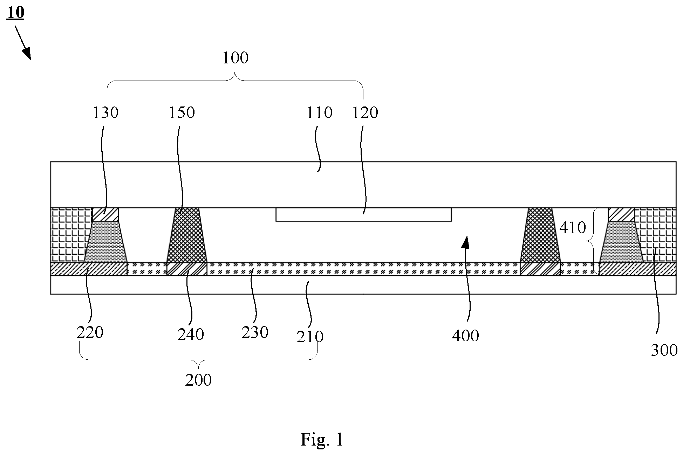

In particular, reference is now made to Fig. 1, which shows a schematic cross-sectional view of an SAW filter packaging structure according to an embodiment of the present invention.

As shown in Fig. 1, an SAW filter packaging structure 10 according to an embodiment disclosed herein includes a chip structure 100, a carrier structure 200 and a plastic packaging layer 300 between the chip structure 100 and the carrier structure 200. There is a hollow cavity 400 formed between the chip structure 100 and the carrier structure 200, and the plastic packaging layer 300 is located externally to the hollow cavity 400. Further, the plastic packaging layer 300 extends over at least part of the chip structure 100, thereby providing protection for the chip structure 100 and hence enhancing the reliability of the SAW filter packaging structure 10.

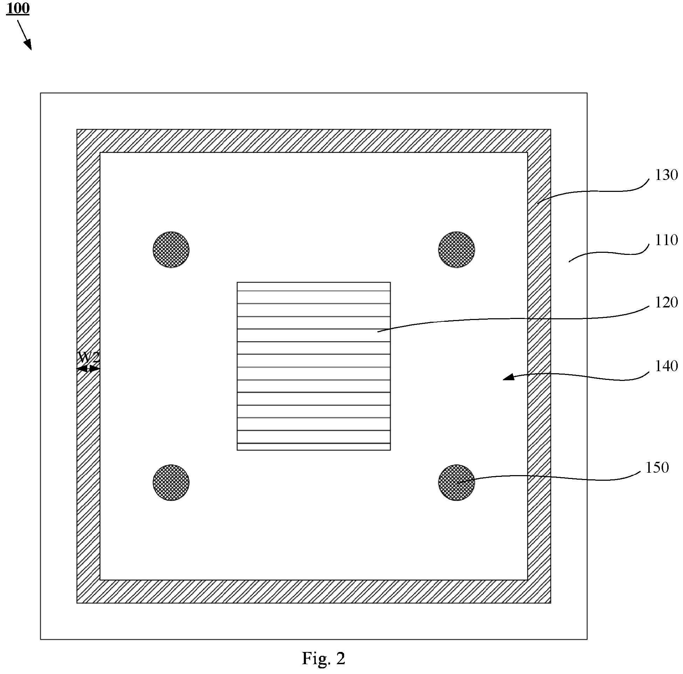

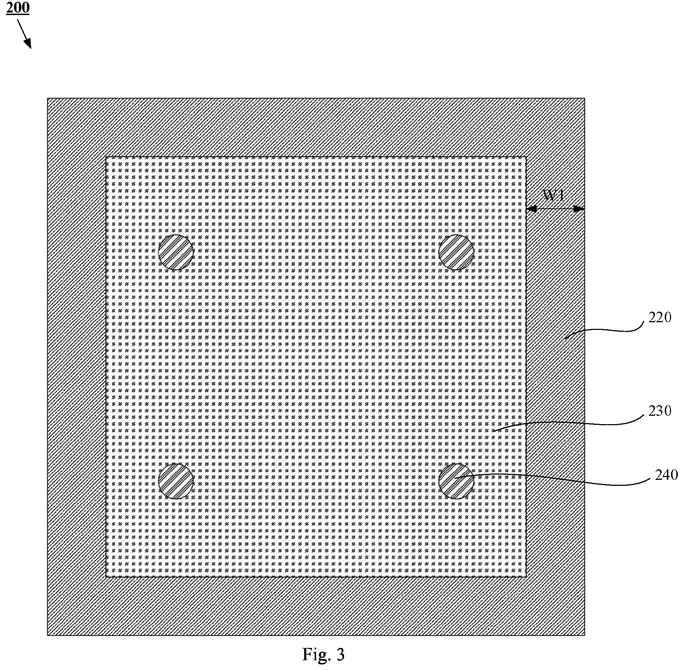

Combined reference is additionally made to Fig. 2, a schematic top view of a chip structure according to an embodiment of the present invention, and Fig. 3, a schematic top view of a carrier structure according to an embodiment of the present invention.

As shown in Figs. 1 and 2, the chip structure 100 includes a substrate 110, an interdigital transducer (IDT) 120 formed on the substrate 110 and a ring-shaped metal wiring structure 130 formed on the substrate 110. The IDT 120 is disposed in an accommodation space 140 defined by the ring-shaped metal wiring structure 130.

The substrate 110 includes a piezoelectric layer (not shown), and the IDT 120 is formed on the piezoelectric layer. The piezoelectric layer may be formed of, for example, lithium tantalite (LT), lithium niobate (LN), aluminum nitride (AlN), lead zirconate titanate (PZT) piezoelectric ceramic, zinc oxide (ZnO) or the like.

The substrate 110 may also include one or more of a backing layer (not shown), a trap layer (not shown), a first dielectric layer (not shown) and a second dielectric layer (not shown). The backing layer may be a silicon layer, for example. The trap layer may be a polysilicon layer, for example. Each of the first and second dielectric layers may be silicon dioxide, silicon nitride or the like. They may be either the same or different materials.

For example, the substrate 110 may include a backing layer and a first dielectric layer. In this case, the first dielectric layer may reside on the backing layer, and the piezoelectric layer that bears the IDT 120 may in turn reside on the first dielectric layer.

As another example, the substrate 110 may include a backing layer, a trap layer and a first dielectric layer. In this case, the trap layer may reside on the backing layer, and the first dielectric layer may in turn reside on the trap layer. Additionally, the piezoelectric layer that bears the IDT 120 may in turn reside on the first dielectric layer.

As yet another example, the substrate 110 may include a backing layer, a trap layer, a first dielectric layer and a second dielectric layer. In this case, the trap layer may reside on the backing layer, and the first dielectric layer may in turn reside on the trap layer. Additionally, the piezoelectric layer that bear the IDT 120 may in turn reside on the first dielectric layer, and the second dielectric layer may cover the IDT 120.

The chip structure 100 may include one or more IDTs 120. According to an embodiment disclosed herein, the chip structure 100 may include a single IDT 120. According to alternative embodiments disclosed herein, the chip structure 100 may include a plurality of IDTs 120, such as two, three or more IDTs 120. Each IDT 120 may be flanked on both sides by reflectors (not shown).

The IDT 120 may be made of a metal. Particular examples of the metal may include gold, silver, aluminum, copper, tungsten, titanium, nickel and metal alloys. The ring-shaped metal wiring structure 130 may be made of gold, silver, aluminum, copper, tungsten, titanium, nickel, a metal alloy or the like. The material of the ring-shaped metal wiring structure 130 may be the same as that of the IDT 120. In addition, the IDT 120 and the ring-shaped metal wiring structure 130 may be made from a single metal layer in a single semiconductor process. This allows for a simpler process with lower cost. According to alternative embodiments disclosed herein, the IDT 120 may be formed prior to the formation of the ring-shaped metal wiring structure 130, or the ring-shaped metal wiring structure 130 may be formed before the IDT 120 is formed. Preferably, the ring-shaped metal wiring structure 130 has a thickness greater than or equal to that of the IDT 120.

With continued reference to Figs. 1 and 2, the IDT 120 is spaced apart from the ring-shaped metal wiring structure 130. Preferably, the IDT 120 is located at the center of the accommodation space 140. That is, the IDT 120 is equidistantly or substantially equidistantly spaced from an inner edge of the ring-shaped metal wiring structure 130.

As shown in Fig. 2, according to an embodiment disclosed herein, the ring-shaped metal wiring structure 130 is a rectangular ring. According to alternative embodiments disclosed herein, the ring-shaped metal wiring structure 130 may have a different shape, such as circular, elliptic, diamond-like or irregular. Additionally, the inner edge of the ring-shaped metal wiring structure 130 may be shaped identically to its outer edge, or not. For example, both the inner and outer edges of the ring-shaped metal wiring structure 130 may be rectangular, as shown in Fig. 2. Alternatively, the inner edge of the ring-shaped metal wiring structure 130 may be rectangular, while the outer edge may be circular or shaped otherwise.

As shown in Figs. 1 and 2, the chip structure 100 further includes a plurality of metal bump structures 150 formed on the substrate 110, each having a surface raised over that of the IDT 120. Additionally, the surface of each metal bump structure 150 may also be raised over that of the ring-shaped metal wiring structure 130. The metal bump structures 150 may be made of a metal, such as tin. Preferably, there are a plurality of metal bump structures 150.

According to an embodiment disclosed herein, the metal bump structures 150 are disposed within the accommodation space 140. Additionally, the metal bump structures 150 may be spaced apart from the ring-shaped metal wiring structure 130. According to an embodiment disclosed herein, the metal bump structures 150 may also be spaced apart from the IDT 120. According to alternative embodiments disclosed herein, the metal bump structures 150 may be connected to the IDT 120.

Referring to Figs. 1 and 3, the carrier structure 200 includes a carrier 210 and a ring-shaped metal pad 220 formed on the carrier 210. For example, the carrier 210 may be formed of a semiconductor, a metal, a polymer, or the like.

The carrier structure 200 further includes a solder mask layer 230 formed on the carrier 210, and the ring-shaped metal pad 220 is exposed from the solder mask layer 230. According to an embodiment disclosed herein, a surface of the ring-shaped metal pad 220 is flush with a surface of the solder mask layer 230, and the entire ring-shaped metal pad 220 is exposed from the solder mask layer 230. According to alternative embodiments disclosed herein, the surface of the solder mask layer 230 may be higher than the surface of the ring-shaped metal pad 220, and the entirety or part of the ring-shaped metal pad 220 may be exposed from the solder mask layer 230. Still alternatively, the surface of the solder mask layer 230 may be lower than the surface of the ring-shaped metal pad 220, and the ring-shaped metal pad 220 may be entirely exposed from the solder mask layer 230. Specifically, the ring-shaped metal pad 220 may be exposed entirely or in part in an opening (not shown) formed in the solder mask layer 230.

With continued reference to Figs. 1 and 3, the carrier structure 200 further includes solder pads 240 formed on the carrier 210. Preferably, there are a plurality of solder pads 240. Preferably, there are as many solder pads 240 as there are metal bump structures 150, and the solder pads 240 are aligned with the respective metal bump structures 150.

According to an embodiment disclosed herein, the solder pads 240 may be made of the same material as the ring-shaped metal pad 220. More preferably, the solder pads 240 and the ring-shaped metal pad 220 may be made from a single metal layer in a single semiconductor process. This allows for a simpler process with lower cost. According to alternative embodiments disclosed herein, the solder pads 240 may be formed prior to the formation of the ring-shaped metal pad 220, or the ring-shaped metal pad 220 may be formed before the solder pads 240 are formed. The solder pads 240 may have a thickness greater than, equal to or less than that of the ring-shaped metal pad 220.

With combined reference to Figs. 1 to 3, at least part of the ring-shaped metal wiring structure 130 may reside on, and therefore be connected to, at least part of the ring-shaped metal pad 220. The entirety of the ring-shaped metal wiring structure 130 may reside on the entirety of the ring-shaped metal pad 220. Alternatively, the entirety of the ring-shaped metal wiring structure 130 may reside on part of the ring-shaped metal pad 220. Still alternatively, part of the ring-shaped metal wiring structure 130 may reside on the entirety of the ring-shaped metal pad 220. Yet still alternatively, part of the ring-shaped metal wiring structure 130 may reside on part of the ring-shaped metal pad 220. Correspondingly, the two edges of the ring-shaped metal wiring structure 130 may be aligned with the respective edges of the ring-shaped metal pad 220. Alternatively, at least one edge of the ring-shaped metal wiring structure 130 may be located beyond the respective edge(s) of the ring-shaped metal pad 220. Still alternatively, at least one edge of the ring-shaped metal pad 220 may be located beyond the respective edge(s) of the ring-shaped metal wiring structure 130.

Preferably, the ring-shaped metal pad 220 has an annular width W1, which is greater than or equal to an annular width W2 of the ring-shaped metal wiring structure 130. This allows the ring-shaped metal wiring structure 130 and the ring-shaped metal pad 220 that are connected to each other to together define a barrier wall structure 410, which may also be ring-shaped. In the illustrated embodiment, the structure is a rectangular ring.

According to an embodiment disclosed herein, both the ring-shaped metal pad 220 and the ring-shaped metal wiring structure 130 are shaped as rectangular rings. According to alternative embodiments disclosed herein, both the ring-shaped metal pad 220 and the ring-shaped metal wiring structure 130 may be shaped, for example, as circular rings, irregularly-shaped rings, or otherwise-shaped rings. Preferably, the ring-shaped metal pad 220 has the same shape as the ring-shaped metal wiring structure 130.

As shown in Fig. 1, according to an embodiment disclosed herein, the barrier wall structure 410 defined by the ring-shaped metal wiring structure 130 and the ring-shaped metal pad 220 that are connected to each other seal the hollow cavity 400 between the chip structure 100 and the carrier structure 200, and the IDT 120 is enclosed in the hollow cavity 400. The plastic packaging layer 300 surrounds the barrier wall structure 410. That is, the plastic packaging layer 300 is located externally to the hollow cavity 400. With the barrier wall structure 410 blocking the influence of encapsulation, the SAW filter packaging structure 10 exhibits very high stability and reliability.

Preferably, at least one edge of the ring-shaped metal pad 220 is located beyond the respective edge(s) of the ring-shaped metal pad 220. As shown in Fig. 1, according to an embodiment disclosed herein, the outer edge of the ring-shaped metal pad 220 may be located beyond the outer edge of the ring-shaped metal wiring structure 130. According to alternative embodiments disclosed herein, the inner edge of the ring-shaped metal pad 220 may also be located beyond the inner edge of the ring-shaped metal wiring structure 130. This allows the two to be connected in a more reliable manner, enhancing the ability of the hollow cavity 400 to block the influence of encapsulation.

According to an embodiment disclosed herein, the ring-shaped metal wiring structure 130 and the ring-shaped metal pad 220 may be connected to each other by soldering with a solder paste, which may be printed, preformed into a layer, or provided in another form. Soldering the two together enables them to be connected even more reliably, thereby allowing the hollow cavity 400 to be even better sealed and blocked from the influence of encapsulation. As a result, the SAW filter packaging structure 10 has even higher stability and reliability. According to alternative embodiments disclosed herein, the ring-shaped metal wiring structure 130 and the ring-shaped metal pad 220 may be connected by flux soldering, an applied adhesive, or an adhesive tape.

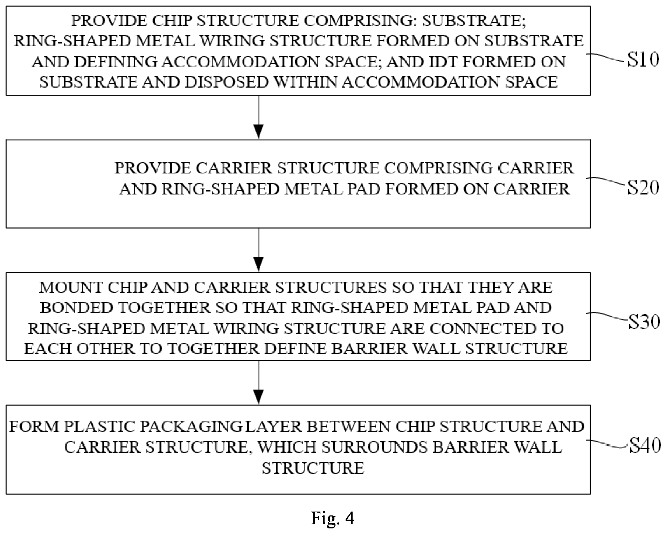

There is also provided herein a method of manufacturing an SAW filter packaging structure. Reference is now made to Fig. 4, a schematic flowchart of a method of manufacturing an SAW filter packaging structure according to an embodiment of the present invention. As shown in Fig. 4, the method includes the steps of:
S10) providing a chip structure including a substrate, an IDT formed on the substrate and a ring-shaped metal wiring structure formed on the substrate, the ring-shaped metal wiring structure defining an accommodation space, the IDT disposed in the accommodation space;
S20) providing a carrier structure including a carrier and a ring-shaped metal pad formed on the carrier;
S30) mounting the chip structure and the carrier structure so that they are bonded together, with the ring-shaped metal wiring structure and the ring-shaped metal pad being connected to each other to together define a barrier wall structure; and
S40) forming a plastic packaging layer between the chip structure and the carrier structure, which surrounds the barrier wall structure.

Step S10 may precede, occur in parallel to, or succeed step S20.

In step S10, a chip structure is provided, which includes a substrate, an IDT formed on the substrate and a ring-shaped metal wiring structure formed on the substrate. The ring-shaped metal wiring structure defines an accommodation space, and the IDT is disposed in the accommodation space. In particular, this step may include the sub-steps of:
S11) providing a wafer defining a plurality of device areas;
S12) forming in each of the device areas, the ring-shaped metal wiring structure that defines the accommodation space and the IDT that is disposed within the accommodation space; and
S13) dicing the wafer into a plurality of the chip structures, in each of which the wafer serves as the substrate.

According to an embodiment disclosed herein, a wafer may be first provided, which may have a plurality of device areas and dicing lanes delimiting the device areas.

Next, a metal layer covering the wafer is formed. Specifically, the wafer may cover the device areas and the dicing lanes. Subsequently, an etching process may be performed to simultaneously form the IDTs 120 and the ring-shaped metal wiring structures 130. According to alternative embodiments disclosed herein, the IDTs 120 and the ring-shaped metal wiring structures 130 may also be formed in separate processes. For example, the IDTs 120 may be first formed using film-forming and etching processes, and the ring-shaped metal wiring structures 130 may be then formed by sputtering, electroplating, electroless plating or another technique.

According to an embodiment disclosed herein, after the IDTs 120 and the ring-shaped metal wiring structures 130 are formed in the device areas, metal bump structures 150 are further formed in the device areas. According to alternative embodiments disclosed herein, the metal bump structures 150 may also be formed during the mounting of the chip and carrier structures. The present application is not limited in this regard.

According to an embodiment disclosed herein, the wafer is diced along the dicing lanes into a plurality of the chip structures 100. The number of resulting chip structures 100 is equal to that of the device areas. In each of the chip structures 100 in the respective device areas, the wafer serves as the substrate 110.

In step 20, a carrier structure is provided, which includes a carrier and a ring-shaped metal pad formed on the carrier. In particular, this may include the sub-steps of:
S21) providing the carrier; and
S22) forming the ring-shaped metal pad on the carrier.

According to an embodiment disclosed herein, a larger carrier may be first provided, for example, in the form of an entire silicon wafer, a metal or polymer plate of a certain size, or the like. The larger carrier is provided to subsequently carry chip structures 100, enhancing process efficiency. A plurality of ring-shaped metal pads 220 may be then formed on the larger carrier in correspondence with the respective ring-shaped metal wiring structures 130 in the respective chip structures 100. Subsequently, a solder paste or flux may be printed on the larger carrier.

In step S30, the chip structure and the carrier structure are mounted so that they are bonded together, with the ring-shaped metal wiring structure and the ring-shaped metal pad being connected to each other to together define a barrier wall structure. In particular, this step may include the sub-steps of:
S31) positioning the chip structure onto the carrier structure; and
S32) affixing the chip structure to the carrier structure by reflow soldering so that the ring-shaped metal wiring structure and the ring-shaped metal pad are connected to together define the barrier wall structure.

In particular, the chip structures 100 may be positioned onto the respective ring-shaped metal pads 220 on the larger carrier, and a reflow soldering process may be then performed to solder the chip structures 100 to the respective carrier structures 200. As a result of the soldering process, the ring-shaped metal wiring structures 130 and the ring-shaped metal pads 220 are affixed to each other to together define the respective barrier wall structures 410. Thus, a plurality of assemblies each consisting of integrated chip and carrier structures 100, 200 are obtained.

According to alternative embodiments disclosed herein, the mounting of the chip and carrier structures may be accomplished using an applied adhesive. In this case, a surface of the solder mask layer 230 is preferably higher than a surface of the ring-shaped metal pad 220. This can prevent overflow of the applied adhesive, resulting in improved mounting quality and reliability. Preferably, the mounting is followed by a baking or light-curing process, which allows for more stable mounting.

Next, in step S40, a plastic packaging layer is formed between the chip and carrier structures so as to surround the barrier wall structure. According to an embodiment disclosed herein, an encapsulation process may be performed to form a plastic packaging layer 300 among the assemblies of integrated chip and carrier structures 100, 200, which seals the IDTs 120 therein, thereby obtaining integrated SAW filter packaging structures 10.

According to an embodiment disclosed herein, the larger carrier may be diced after step S40, thereby obtaining a plurality of the SAW filter packaging structures 10. That is, a dicing process may be performed on the larger carrier, thereby singulating the integrated SAW filter packaging structures 10 into the individual SAW filter packaging structures 10.

As discussed above, the present invention provides an SAW filter packaging structure and a method of manufacturing the structure, in which a ring-shaped metal wiring structure formed on a substrate and a ring-shaped metal pad formed on a carrier are connected to each other to together define a barrier wall structure, which blocks the influence of encapsulation, thereby providing very high stability and reliability. In addition, the ring-shaped metal wiring structure formed on the substrate and the ring-shaped metal pad formed on the carrier are both simple in structure, resulting in reductions in process complexity and fabrication cost.

As used herein, any reference to "one embodiment" or "some embodiments" means that a particular feature, structure, or characteristic described in connection with the embodiment is included in at least one embodiment or at least some embodiments disclosed herein. Therefore, the appearances of the phrase "in one embodiment" or "in some embodiments" in various places in the specification are not necessarily all referring to the same one or some embodiments. Further, in one or more embodiments, features, structures or characteristics may be combined in any suitable combination and/or sub-combination.

While a few particular embodiments of the present application have been described in detail by way of examples, those skilled in the art will understand that the foregoing examples are provided for illustration only rather than any limitation on the scope of the application. The various embodiments disclosed herein can be combined in any combination, without departing from the spirit and scope of the application. Those skilled in the art will also understand that various modifications can be made to the embodiments, without departing from the scope and spirit of the application. The scope of the application is defined by the appended claims.

## Claims

1. A surface acoustic wave filter packaging structure, **characterized in that** the surface acoustic wave filter packaging structure comprises:
a chip structure, the chip structure comprising a substrate, an interdigital transducer formed on the substrate and a ring-shaped metal wiring structure formed on the substrate, the ring-shaped metal wiring structure defining an accommodation space, the interdigital transducer disposed within the accommodation space;
a carrier structure, the carrier structure comprising a carrier and a ring-shaped metal pad formed on the carrier, the carrier structure bonded to the chip structure, the ring-shaped metal pad and the ring-shaped metal wiring structure are connected to each other to together form a barrier wall structure; and
a plastic packaging layer, the plastic packaging layer being located between the chip structure and the carrier structure so as to surround the barrier wall structure.

2. The surface acoustic wave filter packaging structure of claim 1, wherein the ring-shaped metal wiring structure and the ring-shaped metal pad are connected to each other by soldering with a solder paste or flux, or by an applied adhesive or adhesive tape.

3. The surface acoustic wave filter packaging structure of claim 1, wherein at least part of the ring-shaped metal wiring structure overlaps with at least part of the ring-shaped metal pad.

4. The surface acoustic wave filter packaging structure of claim 1, wherein the ring-shaped metal pad has an annular width, which is greater than or equal to an annular width of the ring-shaped metal wiring structure.

5. The surface acoustic wave filter packaging structure of claim 1, wherein at least one of edges of the ring-shaped metal pad protrudes beyond a respective at least one of respective edges of the ring-shaped metal wiring structure.

6. The surface acoustic wave filter packaging structure of any one of claims 1 to 5, wherein the carrier structure further comprises a solder mask layer formed on the carrier, the ring-shaped metal pad is exposed from the solder mask layer.

7. The surface acoustic wave filter packaging structure of any one of claims 1 to 5, wherein the chip structure further comprises a plurality of metal bump structures formed on the substrate.

8. The surface acoustic wave filter packaging structure of claim 7, wherein the carrier structure further comprises solder pads formed on the carrier, which are connected to the metal bump structures.

9. The surface acoustic wave filter packaging structure of any one of claims 1 to 5, wherein the plastic packaging layer extends over at least part of the chip structure.

10. The surface acoustic wave filter packaging structure of claim 7, wherein the metal bump structures are spaced apart from the ring-shaped metal wiring structure.

11. The surface acoustic wave filter packaging structure of claim 1, wherein the ring-shaped metal wiring structure is made of the same material as the interdigital transducer, and/or
wherein the ring-shaped metal wiring structure has a thickness greater than or equal to a thickness of the interdigital transducer.

12. A method of manufacturing a surface acoustic wave filter packaging structure, **characterized in that** the method comprises:
providing a chip structure, the chip structure comprising a substrate, an interdigital transducer formed on the substrate and a ring-shaped metal wiring structure formed on the substrate, the ring-shaped metal wiring structure defining an accommodation space, the interdigital transducer disposed within the accommodation space;
providing a carrier structure, the carrier structure comprising a carrier and a ring-shaped metal pad formed on the carrier;
attaching the chip structure and the carrier structure, so that the chip structure and the carrier structure are bonded to each other and the ring-shaped metal wiring structure and the ring-shaped metal pad are connected to each other to form a barrier wall structure; and
forming a plastic packaging layer, the plastic packaging layer being located between the chip structure and the carrier structure, which surrounds the barrier wall structure.

13. The method of manufacturing the surface acoustic wave filter packaging structure of claim 12, wherein providing the chip structure comprises:
providing a wafer, the wafer defining a plurality of device areas;
forming the interdigital transducer and the ring-shaped metal wiring structure in each of the device areas, the ring-shaped metal wiring structure defining the accommodation space, and the interdigital transducer being disposed within the accommodation space; and
dicing the wafer into a plurality of the chip structures, the wafer of the device areas serving as the substrate.

14. The method of manufacturing the surface acoustic wave filter packaging structure of claim 12, wherein the chip structure and the carrier structure are attached by soldering with a printed solder paste or flux, or by an applied adhesive or adhesive tape, so that the chip structure and the carrier structure are bonded to each other and the ring-shaped metal wiring structure and the ring-shaped metal pad are connected to each other to form the barrier wall structure.

15. The method of manufacturing the surface acoustic wave filter packaging structure of claim 12, wherein in the step of providing the chip structure, the chip structure further comprises a plurality of metal bump structures formed on the substrate,
wherein in the step of providing the carrier structure, the carrier structure further comprises solder pads formed on the carrier; and
wherein in the step of attaching the chip structure and the carrier structure, the solder pads are connected to the metal bump structures.
